# EUROPÄISCHE PATENTANMELDUNG

(11) **EP 1 906 498 A1**
(43) Veröffentlichungstag der Anmeldung: **02.04.2008**
(21) Anmeldenummer: 07017398.4
(22) Anmeldetag: 05.09.2007
(51) Int. Cl.: H01S 5/223, H01S 5/22, H01S 5/06, H01S 5/183

(54) **Halbleiterlaser mit Absorberzone zur Dämpfung höherer Moden**

(30) Priorität: 29.09.2006 DE 102006046297
(71) Anmelder: OSRAM Opto Semiconductors GmbH, 93055 Regensburg (DE)
(72) Erfinder: Eichler, Christoph, Dr., 93105 Tegernheim (DE); Lell, Alfred, 93142 Maxhütte-Haidhof (DE); Rumbolz, Christian, 93138 Lappersdorf (DE)
(74) Vertreter: Epping - Hermann - Fischer

(57) **Zusammenfassung**

Die Erfindung gibt einen Halbleiterlaser (1) mit einer Halbleiter-Schichtenfolge (2), die eine aktive Zone (3) zur Erzeugung von elektromagnetischer Strahlung umfasst, und einer Absorberzone (4) zur Dämpfung höherer Moden an, wobei die Absorberzone (4) innerhalb der Halbleiter-Schichtenfolge (2) angeordnet ist oder an die Halbleiter-Schichtenfolge (2) angrenzt.

## Beschreibung

Die Erfindung betrifft einen Halbleiterlaser, insbesondere einen Einmoden-Halbleiterlaser.

Diese Patentanmeldung beansprucht die Priorität der deutschen Patentanmeldung 102006046297.1, deren Offenbarungsgehalt hiermit durch Rückbezug aufgenommen wird.

Für viele Anwendungen sind Laser mit guter Strahlqualität, hoher Kohärenzlänge und geringer spektraler Breite erwünscht oder sogar notwendig. Diese Eigenschaften sind insbesondere mit Einmoden-Lasern (Single-Mode-Lasern), wie beispielsweise DFB-Lasern, oberflächenemittierenden Halbleiterlasern (VCSEL-Vertical Cavity Surface Emitting Laser) oder Ridgelasern erzielbar.

In der Patentschrift US 6,711,197 B2 ist ein Ridgelaser beschrieben, der eine p-Mantelschicht aus AlGaN aufweist, wobei auf der p-Mantelschicht ein SiO₂-Film und ein dem SiO₂-Film nachgeordneter Si-Film zur Absorption höherer Moden angeordnet sind.

Bei dem beschriebenen Laser muss der SiO₂-Film ausreichend dünn sein, damit höhere Moden bis in den Si-Film reichen und absorbiert werden können. Die geringe Dicke des SiO₂-Films kann sich nachteilig auf die elektrischen Eigenschaften auswirken, insbesondere kann sich die Durchschlagfestigkeit reduzieren oder es können Leckströme auftreten.

Es ist Aufgabe der vorliegenden Erfindung, einen Halbleiterlaser anzugeben, der eine vergleichsweise hohe Strahlqualität bei gleichzeitig verbesserten elektrischen Eigenschaften liefert.

Diese Aufgabe wird durch einen Halbleiterlaser gemäß Patentanspruch 1 gelöst. Vorteilhafte Ausgestaltungen des Halbleiterlasers sind Gegenstand der abhängigen Ansprüche.

Ein erfindungsgemäßer Halbleiterlaser umfasst eine Halbleiter-Schichtenfolge, die eine aktive Zone zur Erzeugung von elektromagnetischer Strahlung aufweist, und umfasst eine Absorberzone zur Dämpfung höherer Moden, wobei die Absorberzone innerhalb der Halbleiter-Schichtenfolge angeordnet ist oder an die Halbleiter-Schichtenfolge angrenzt.

Ohne Absorberzone treten insbesondere höhere Moden 1. und 2. Ordnung auf. Vorteilhafterweise kann mittels der Absorberzone der Anteil der höheren Moden deutlich reduziert und so die Strahlqualität entsprechend verbessert werden. Die jeweiligen im Rahmen der Erfindung vorgeschlagenen Maßnahmen zur Absorption der höheren Moden sind vorzugsweise nicht modenspezifisch, sondern für die auftretenden höheren Moden insgesamt geeignet.

Der erfindungsgemäße Halbleiterlaser kann in zwei Ausführungsformen hergestellt werden: als kantenemittierender Halbleiterlaser oder oberflächenemittierender Halbleiterlaser. Beim kantenemittierenden Halbleiterlaser erfolgt die Emission in Ausdehnungsrichtung der gepumpten aktiven Zone und die Laserstrahlung tritt über die Seitenflanken der aktiven Zone aus. Beim oberflächenemittierenden Halbleiterlaser tritt die Laserstrahlung im rechten Winkel zur gepumpten aktiven Zone aus.

Die aktive Zone kann beispielsweise einen pn-Übergang, eine Doppelheterostruktur, einen Einfach-Quantentopf oder besonders bevorzugt eine Mehrfach-Quantentopfstruktur (MQW) aufweisen. Solche Strukturen sind dem Fachmann bekannt und werden daher an dieser Stelle nicht näher erläutert. Beispiele für MQW-Strukturen sind in den Druckschriften WO 01/39282, WO 98/31055, US 5,831,277, EP 1 017 113 und US 5,684,309 beschrieben, deren Offenbarungsgehalt die MQW-Strukturen betreffend hiermit durch Rückbezug aufgenommen wird.

Gemäß einer bevorzugten Variante weist die Absorberzone ein absorbierendes Material auf.

Gemäß einer weiter bevorzugten Variante ist das absorbierende Material ein Oxid oder Nitrid, insbesondere ein ITO oder ein Oxid oder Nitrid von Si, Ti, A1, Ga, Nb, Zr, Ta, Hf, Zn, Mg, Rh, In. Diese Materialien sind bei einem auf Nitrid-Verbindungshalbleitern basierenden Halbleiterlaser, wie im Rahmen der Erfindung bevorzugt, besonders geeignet.

"Auf Nitrid-Verbindungshalbleitern basierend" bedeutet im vorliegenden Zusammenhang, dass zumindest eine Schicht der Halbleiter-Schichtenfolge ein Nitrid-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (A1, Ga, In, N), auch wenn diese teilweise durch geringe Mengen weiterer Stoffe ersetzt sein können.

Bevorzugt weist die von dem Halbleiterlaser emittierte Strahlung eine Wellenlänge im ultravioletten, blauen oder grünen Spektralbereich auf.

Vorzugsweise ist der Absorptionsgrad der Absorberzone mittels der Materialzusammensetzung eingestellt. Insbesondere ist die Zusammensetzung des absorbierenden Materials nicht-stöchiometrisch. Dies bedeutet, dass hinsichtlich der Materialzusammensetzung keine Stöchiometrie vorliegt, die Zusammensetzung also nicht quantitativen Gesetzen folgt. Während die Zusammensetzung SiO₂ als stöchiometrisch bezeichnet werden kann, ist eine vorliegend bevorzugte Zusammensetzung, SiO_{1.6}, nicht-stöchiometrisch.

Vorteilhafterweise kann bei der genannten Variante die Materialzusammensetzung beziehungsweise der Absorptionsgrad auch noch nachträglich, das heißt zum Beispiel nach der Herstellung des Halbleiterlasers oder ersten Messungen der Strahlqualität geändert werden. Insbesondere kann ein stark absorbierendes Material wie Si gezielt oxidiert und dadurch der Absorptionsgrad reduziert werden. Dies hat beispielsweise den Vorteil, dass mehrere Halbleiterlaser gemeinsam hergestellt werden und nachträglich je nach Anforderung (zum Beispiel mit geringem Schwellstrom oder hoher Nebenmodenunterdrückung) entsprechend konfiguriert werden können.

Dieser Vorteil ist auch bei einer weiteren Ausgestaltung gegeben, bei welcher die Absorberzone ein absorbierendes dotiertes Halbleitermaterial aufweist. Vorzugsweise ist hierbei der Absorptionsgrad mittels der Dotierung eingestellt. Da mittels der Dotierung die Bandlücke des Halbleitermaterials variiert werden kann, ist es möglich die Bandlücke derart zu wählen, dass höhere Moden absorbiert werden, während die Grundmode im Halbleiterlaser verstärkt und schließlich ausgekoppelt wird. Bei dem erfindungsgemäßen Halbleiterlaser ist die Absorberzone besonders bevorzugt mit Mg dotiert. Als Halbleitermaterialien sind ein auf Phosphid, Arsenid oder Nitrid basierendes Halbleitermaterial, Si oder Ge geeignet.

Alternativ ist das Halbleitermaterial undotiert. Beispielsweise kann das Halbleitermaterial AlₙGaₘIn₁₋ₙ₋ₘP, AlₙGaₘIn₁₋ₙ₋ₘAs oder AlₙGaₘIn₁₋ₙ₋ₘN sein, wobei 0 ≤ n ≤ 1, 0 ≤ m ≤ 1 und n+m ≤ 1 ist. Hierbei kann mittels der Materialzusammensetzung des Halbleitermaterials, insbesondere durch den Variation des In- beziehungsweise Al-Anteils, ebenfalls die Bandlücke und somit der Absorptionsgrad in der Absorberzone eingestellt werden.

Gemäß einer bevorzugten Ausgestaltung weist die Absorberzone ein dielektrisches Material auf. Insbesondere kann das dielektrische Material ein Oxid oder Nitrid, wie oben aufgelistet, sein.

Gemäß einer besonders bevorzugten Ausgestaltung ist die Absorberzone elektrisch isolierend. Dadurch kann die Absorberzone vorteilhafterweise zusätzlich als Passivierung zur Verhinderung von Durchschlägen oder Leckströmen dienen. Die Absorberzone kann beispielsweise in einem der aktiven Zone zugewandten Bereich Siliziumnitrid und in einem der aktiven Zone abgewandten Bereich Siliziumoxid aufweisen. Bei Siliziumnitrid kann auf einfache Weise eine nichtstöchiometrische Materialzusammensetzung erzielt und dadurch der Absorptionsgrad vorteilhaft eingestellt werden. Hingegen ist Siliziumoxid zur Passivierung geeignet.

Insbesondere kann die elektrisch isolierende Absorberzone als Stromblende dienen. Somit kann die Stromeinprägung in den Halbleiterlaser auf einen gewünschten Bereich begrenzt werden.

Bei einer weiteren Ausführung ist die Absorberzone mit absorbierenden Einlagerungen versetzt. Zweckmäßigerweise sind die Einlagerungen dazu geeignet, höhere Moden zu dämpfen beziehungsweise zu absorbieren.

Vorzugsweise ist der Absorptionsgrad der Absorberzone mittels des Anteils der Einlagerungen eingestellt. Da aufgrund der Herstellung Unterschiede in den optischen Eigenschaften der Halbleiterlaser auftreten können, ist ein einstellbarer Absorptionsgrad besonders vorteilhaft.

Die Einlagerungen können Atome, Cluster oder Partikel sein, die ein Metall, Halbleitermaterial oder organisches Material enthalten oder daraus bestehen. Insbesondere können die Einlagerungen Ti, Pt, Si oder C enthalten oder daraus bestehen.

Die Absorberzone, welche die Einlagerungen aufweist, enthält vorzugsweise ein Oxid oder Nitrid, insbesondere ein ITO oder ein Oxid oder Nitrid von Si, Ti, A1, Ga, Nb, Zr, Ta, Hf, Zn, Mg, Rh, In oder ein Polyimid.

Vorzugsweise ist der Absorptionsgrad mittels des Anteils der Einlagerungen eingestellt.

Weiterhin kann die Absorberzone ein Übergitter aufweisen, das aus einer Abfolge von mindestens einer Schicht, die ein absorbierendes Material enthält, und mindestens einer Schicht, die ein weniger absorbierendes Material enthält, gebildet ist. Zum Beispiel kann als absorbierendes Material Si und als wenig absorbierendes Material ein Oxid oder Nitrid, wie oben aufgelistet, verwendet werden.

Ferner kann der Absorptiongrad der Absorberzone mittels Diffusion von Absorbermaterial in die Absorberzone beziehungsweise aus der Absorberzone eingestellt sein. Diese Variante ermöglicht eine Regulierung der Überlappung der Absorberzone mit dem Strahlungsfeld des Halbleiterlasers. Mittels einer Diffusion des Absorbermaterials näher zur aktiven Zone, kann die Überlappung mit dem Strahlungsfeld erhöht werden, wodurch eine stärkere Absorption erzielt werden kann. Umgekehrt kann durch eine Diffusion des Absorbermaterials weg vom Strahlungsfeld, eine Verringerung der Überlappung mit dem Strahlungsfeld bewirkt werden, wodurch eine geringere Absorption stattfindet. Dabei besteht die Möglichkeit, die Diffusion thermisch und/oder elektrisch zu unterstützen oder zu steuern.

Bei einer besonderen Ausgestaltung des Halbleiterlasers ist die Absorberzone strukturiert. Mittels der Strukturierung kann aufgrund der Verkleinerung der absorbierenden Fläche im Vergleich zu einer ganzflächigen Aufbringung die Absorption in der Absorberzone reduziert werden. Dies ist insbesondere bei einem stark absorbierenden Material vorteilhaft. Beispielsweise kann die Absorberzone eine punktförmige, streifenförmige oder feldlinienartige Struktur aufweisen. Darüber hinaus sind einfache oder sich mehrfach wiederholende Strukturen denkbar. Die Absorberzone kann zunächst ganzflächig aufgebracht und anschließend strukturiert werden oder bereits strukturiert aufgebracht werden. Letzteres ist zum Beispiel bei Resonatorspiegeln vorteilhaft, weil hierdurch keine Beschädigungen oder Verunreinigungen der Resonatorspiegel durch anschließendes Strukturieren zu befürchten sind. Vorteilhafterweise kann durch strukturiertes Aufbringen beziehungsweise durch Änderung der räumlichen Verteilung des Absorbermaterials die Absorption von einzelnen transversalen und/oder longitudinalen Moden gezielt eingestellt werden.

Im Falle eines Arrays aus Halbleiterlasern, bei welchem typischerweise ein in der Mitte angeordneter Halbleiterlaser im Betrieb wärmer wird als ein am Rand angeordneter Halbleiterlaser, kann den unterschiedlichen Betriebsbedingungen durch unterschiedlich gestaltete Absorberzonen Rechnung getragen werden.

Gemäß einer bevorzugten Ausführung des Halbleiterlasers ist die Absorberzone eine zum lateralen epitaktischen Überwachsen (ELOG = Epitaxial Lateral OverGrowth) verwendete Maskenschicht. Die ELOG-Methode ist insbesondere bei einer innerhalb der Halbleiter-Schichtenfolge angeordneten Absorberzone von Vorteil, da hierdurch eine Zone in die Halbleiter-Schichtenfolge eingebaut werden kann, die ein Material enthält, das sich von dem für die Halbleiter-Schichtenfolge verwendeten Halbleitermaterial unterscheidet. Die als ELOG-Maskenschicht dienende Absorberzone kann aufgesputtert oder aufgedampft und strukturiert werden. Nach der Herstellung der Absorberzone wird die Halbleiter-Schichtenfolge weitergewachsen.

Die nachfolgend beschriebenen Ausgestaltungen sind insbesondere bei einer an die Halbleiter-Schichtenfolge angrenzenden Absorberzone geeignet.

Bei einer besonderen Ausführungsform ist die Absorberzone mittels Veränderung der Kristallstruktur der Halbleiter-Schichtenfolge aus einer die Halbleiter-Schichtenfolge abschließenden Schicht gebildet. Dadurch weist die Absorberzone gegenüber der Halbleiter-Schichtenfolge veränderte Absorptionseigenschaften auf. Beispielsweise kann die Kristallstruktur mittels Plasma- oder Temperatureinwirkung verändert werden. Dabei entstehen Plasmaschäden beziehungsweise Absorptionszentren. Im Falle von GaN werden zum Beispiel durch N₂-Abdampfen Ga-Absorptionszentren gebildet.

Weiterhin kann die Absorberzone aus einer Metallschicht gebildet sein. Insbesondere ist die Metallschicht auf die Halbleiter-Schichtenfolge aufgebracht. Jedoch ist es auch denkbar, ein Metall als Absorbermaterial in die Halbleiter-Schichtenfolge zu implantieren oder einzudiffundieren.

Vorzugsweise enthält die Metallschicht ein Metall mit einer niedrige Austrittsarbeit, beispielsweise Ti, A1 oder Cr. Dadurch ist die Metallschicht nicht als elektrischer Kontakt geeignet, und im Bereich der Absorberzone findet keine Stromeinprägung beziehungsweise Pumpen der aktiven Zone statt.

Gemäß einer bevorzugten Variante des Halbleiterlasers ist auf einer der Halbleiter-Schichtenfolge abgewandten Seite der Absorberzone eine elektrische Isolierschicht angeordnet. Insbesondere ist die elektrische Isolierschicht dafür vorgesehen, die elektrischen Eigenschaften des Halbleiterlasers unabhängig von der Absorptionswirkung der an die Halbleiter-Schichtenfolge angrenzenden Absorberzone zu verbessern.

Weiter bevorzugt weist die Isolierschicht einen von der Absorberzone verschiedenen Brechungsindex auf. Vorteilhafterweise kann bei einer hinreichend dünnen Absorberzone die Eindringtiefe des Strahlungsfeldes in die elektrische Isolierschicht über deren Brechungsindex eingestellt werden, wodurch wiederum die Überlappung des Strahlungsfeldes mit der Absorberzone und damit deren Absorptionswirkung eingestellt werden kann. Beispielsweise kann der Brechungsindex durch Oxidation des für die Absorberzone verwendeten Materials verändert werden.

Für eine verschieden starke Dämpfung unterschiedlicher Moden kann sowohl mittels der Materialzusammensetzung in der Absorberzone als auch mittels geeigneter Strukturierung der Absorberzone eine graduelle oder stufenförmige Änderung des Absorptionsgrades erzeugt werden. Zum Beispiel können die Strukturen der Absorberzone unterschiedlich dicht verteilt sein, so dass weiter außen liegende Bereiche einer Mode stärker absorbiert werden.

Bei einer weiteren Ausführungsform weist die Absorberzone einen Metallkontakt zur elektrischen Einstellung der Absorption auf. Im Bereich des Metallkontakts wird die Absorption der aktiven Zone durch Pumpen zwischen transparent und stark absorbierend eingestellt, so dass insbesondere höhere Moden stärker gedämpft werden als die Grundmode.

Grundsätzlich sind alle beschriebenen Varianten bei kantenemittierenden Halbleiterlasern mit Ridgestruktur, mit gewinngeführten Strukturen, beispielsweise Oxidstreifenlaser, bei Laser-Arrays und bei oberflächenemittierenden Halbleiterlasern denkbar.

Vorzugsweise erstreckt sich die Absorberzone bei einem Ridgelaser in lateraler Richtung. Typischerweise erstrecken sich die Schichten der Halbleiter-Schichtenfolge ebenfalls in lateraler Richtung. Insbesondere sind die Absorberzone und die Halbleiter-Schichtenfolge im Wesentlichen parallel zueinander angeordnet. Desweiteren ist die Absorberzone beim Ridgelaser besonders bevorzugt in vertikaler Richtung zur aktiven Zone beabstandet.

Vorteilhafterweise können mit dem erfindungsgemäßen Halbleiterlaser im Vergleich zu herkömmlichen Halbleiterlasern höhere Kink-Levels erzielt werden, das heißt, dass höhere Strahlungsleistungen erreicht werden können, ohne dass transversale Modensprünge auftreten.

Der erfindungsgemäße Halbleiterlaser ist für zahlreiche Applikationen wie zur Datenspeicherung oder zum Laserdruck geeignet.

Im Rahmen der Erfindung kommen zur Herstellung der Absorberzone beispielsweise Sputtern, Aufdampfen, epitaktisches Aufwachsen oder Plasmabeschichten in Frage.

Weitere Merkmale, Vorteile und Weiterbildungen der Erfindung ergeben sich aus den nachfolgend in Verbindung mit den Figuren 1 bis 11 erläuterten Ausführungsbeispielen.

Es zeigen:
Figur 1 eine schematische Querschnittsansicht eines ersten Ausführungsbeispiels eines erfindungsgemäßen Halbleiterlasers,
Figur 2 eine schematische Querschnittsansicht eines zweiten Ausführungsbeispiels eines erfindungsgemäßen Halbleiterlasers,
Figur 3 eine schematische Querschnittsansicht eines dritten Ausführungsbeispiels eines erfindungsgemäßen Halbleiterlasers,
Figur 4 eine schematische Querschnittsansicht eines vierten Ausführungsbeispiels eines erfindungsgemäßen Halbleiterlasers,
Figuren 5a, 5b, 5c, 5d, 5e eine schematische Darstellung von Ausführungsbeispielen von Strukturen erfindungsgemäßer Absorberzonen,
Figur 6 eine schematische Querschnittsansicht eines fünften Ausführungsbeispiels eines erfindungsgemäßen Halbleiterlasers,
Figur 7 eine schematische Querschnittsansicht eines sechsten Ausführungsbeispiels eines erfindungsgemäßen Halbleiterlasers,
Figur 8 eine schematische Querschnittsansicht eines siebten Ausführungsbeispiels eines erfindungsgemäßen Halbleiterlasers,
Figuren 9a und 9b Schaubilder darstellend den internen Verlust eines herkömmlichen Halbleiterlasers und eines erfindungsgemäßen Halbleiterlasers gegenüber der Ätztiefe,
Figuren 10a und 10b Schaubilder darstellend die winkelabhängige Intensitätsverteilung eines herkömmlichen Halbleiterlasers und eines erfindungsgemäßen Halbleiterlasers,
Figuren 11a und 11b zwei Schaubilder darstellend die Schwellgewinncharakteristik von herkömmlichen Ridgelasern.

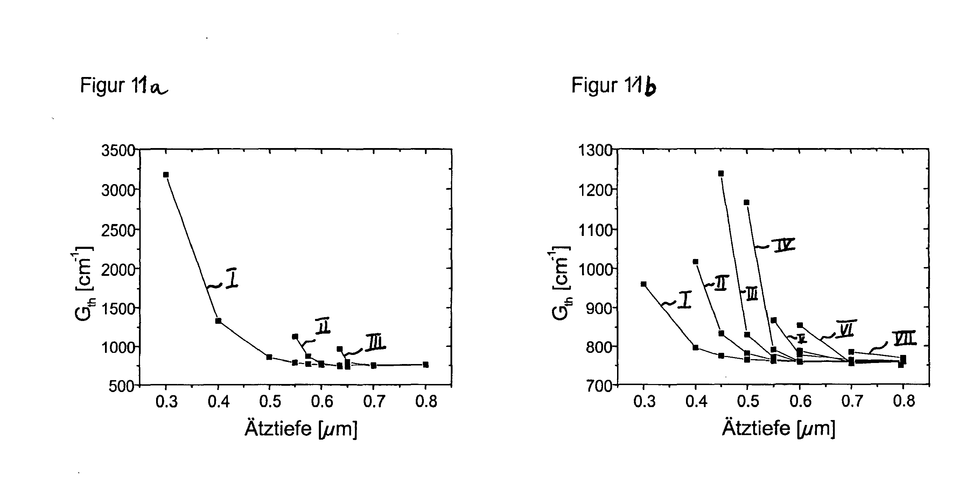

In den Figuren 11a und 11b ist für zwei herkömmliche Ridgelaser jeweils in einem Schaubild der Schwellgewinn Gₜₕ gegen die Ätztiefe aufgetragen.

Figur 11a bezieht sich auf einen Ridgelaser mit einer Ridgebreite von 1,5µm, während sich Figur 11b auf einen Ridgelaser mit einer Ridgebreite von 5µm bezieht. Die verschiedenen Kurven geben den Schwellgewinnverlauf für verschiedene Moden an (Kurve I: Grundmode; Kurve II: 1. Ordnung; Kurve III: 2. Ordnung; Kurve IV: 3. Ordnung; Kurve V: 4. Ordnung; Kurve VI: 6. Ordnung; Kurve VII: 9. Ordnung).

Beiden Schaubildern ist zu entnehmen, dass der Schwellgewinn mit zunehmender Ätztiefe sinkt. Ebenso sinkt der Schwellgewinn mit zunehmender Ridgebreite. Problematisch ist in beiden Fällen, dass bei zunehmender Ätztiefe Moden höherer Ordnung auftreten. Wie aus Figur 11b hervorgeht, schwingen bei einem breiteren Ridge die Moden höherer Ordnung bereits bei geringeren Ätztiefen an.

Im Folgenden werden Möglichkeiten aufgezeigt, wie trotz großer Ätztiefe beziehungsweise trotz eines breiteren Ridges höhere Moden gedämpft werden können.

Die Darstellungen der Halbleiterlaser weisen am unteren Rand eine geschlängelte Linie auf, die verdeutlichen soll, dass eine Halbleiter-Schichtenfolge 2 auf dieser Seite nicht auf eine bestimmte Ausgestaltung festgelegt ist. Auf dieser Seite kommen herkömmliche Ausgestaltungen eines Halbleiterlasers in Frage. Insbesondere kann der Halbleiterlaser dort eine Mantelschicht, eine Wellenleiterschicht, eine Spiegelschicht, ein Substrat und eine Kontaktschicht aufweisen.

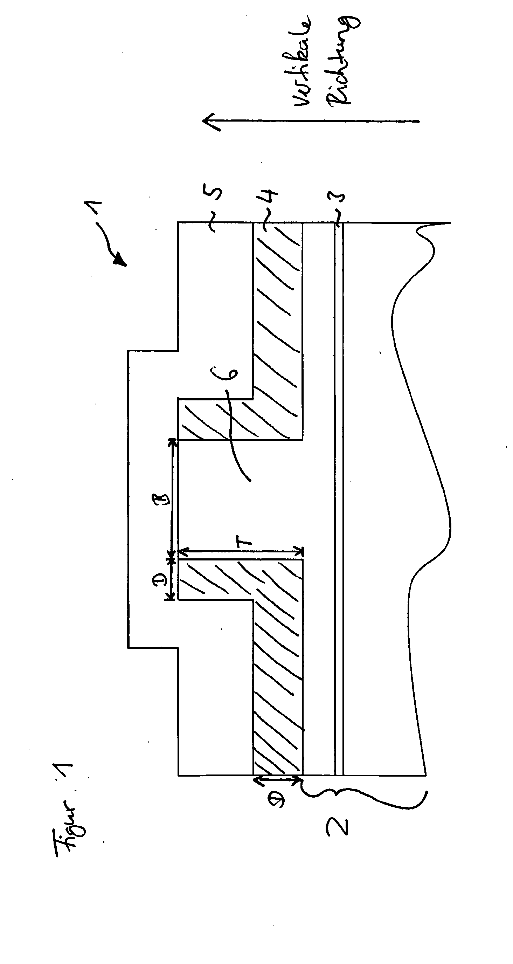

In Figur 1 ist ein Halbleiterlaser 1 dargestellt, der eine Halbleiter-Schichtenfolge 2 aufweist, deren Schichten (nicht einzeln dargestellt) in der angezeigten vertikalen Richtung übereinander angeordnet sind. Die Halbleiter-Schichtenfolge 2 umfasst eine aktive Zone 3, die im Betrieb elektromagnetische Strahlung erzeugt. Vorzugsweise wird die erzeugte Strahlung in diesem Ausführungsbeispiel seitlich emittiert, das heißt in einer zur vertikalen Richtung im Wesentlichen senkrechten Richtung. Die aktive Zone 3 ist aus einem Halbleitermaterial gebildet, das zur Erzeugung von Strahlung einer gewünschten Wellenlänge geeignet ist. Vorzugsweise enthält die aktive Zone 3 ein auf Nitrid basierendes Verbindungshalbleitermaterial, insbesondere GaN, und emittiert Strahlung mit einer Wellenlänge im grünen/blauen Spektralbereich. Die Wellenlänge kann beispielsweise etwa 405nm betragen.

In dem dargestellten Ausführungsbeispiel grenzt eine Absorberzone 4 an die Halbleiter-Schichtenfolge 2. Die Absorberzone 4 ist hierbei ausreichend elektrisch nichtleitend und dick genug, so dass sie zugleich als Passivierung dient, wodurch die Durchschlagsfestigkeit vorteilhaft erhöht ist und Leckströme reduziert sind. Die Dicke D der Absorberzone 4 liegt beispielsweise bei einer Betriebsspannung von etwa 12V bis 15V im Bereich von 250nm. Ferner kann die Absorberzone 4 zwei Materialien, beispielsweise Siliziumnitrid und Siliziumoxid, enthalten, wobei die Materialien insbesondere in übereinander angeordneten Schichten enthalten sein können.

In vertikaler Richtung ist der Absorberzone 4 eine Kontaktschicht 5 zur elektrischen Kontaktierung der Halbleiter-Schichtenfolge 2 nachgeordnet.

Der Halbleiterlaser 1 kann wie dargestellt ein Ridgelaser mit einem Ridge 6 sein. Der Halbleiterlaser 1 weist eine Ätztiefe T und eine Ridgebreite B auf. Die Absorberzone 4 bedeckt die Halbleiter-Schichtenfolge 2, vorzugsweise inklusive der Flanken des Ridges 6. Lediglich ein streifenförmiger Bereich zur Stromeinprägung ist von der Absorberzone 4 unbedeckt. In diesem Bereich grenzt die Kontaktschicht 5 unmittelbar an die Halbleiter-Schichtenfolge 2.

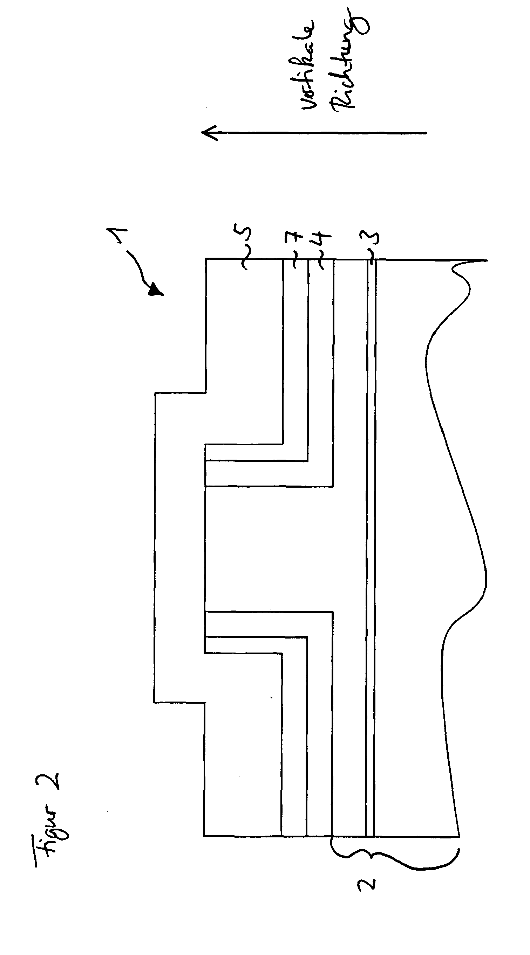

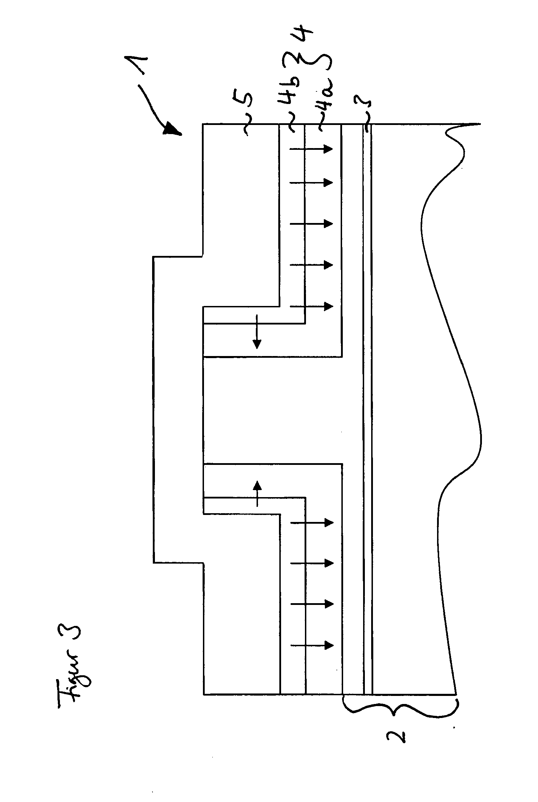

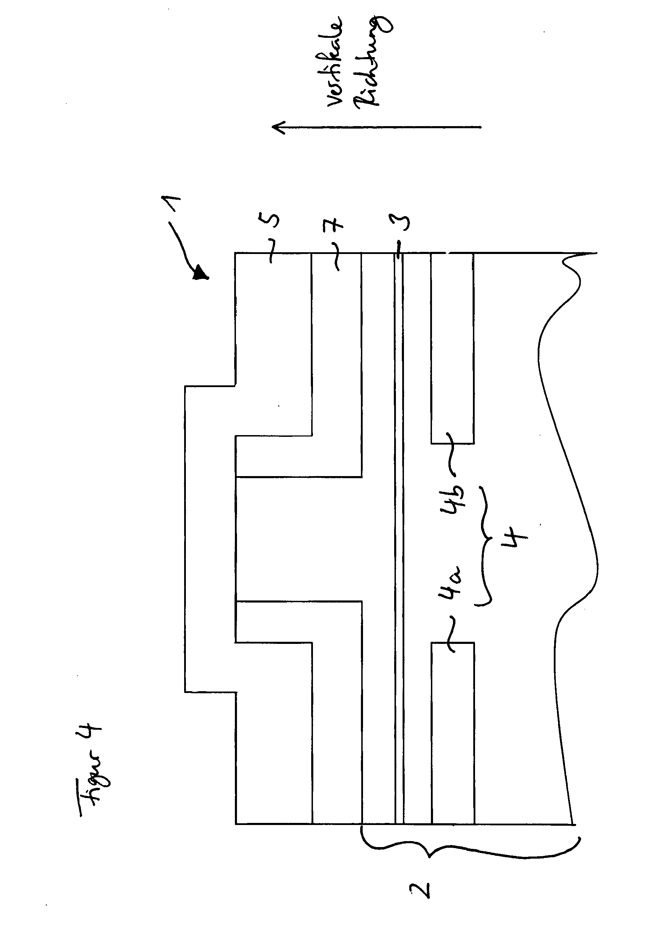

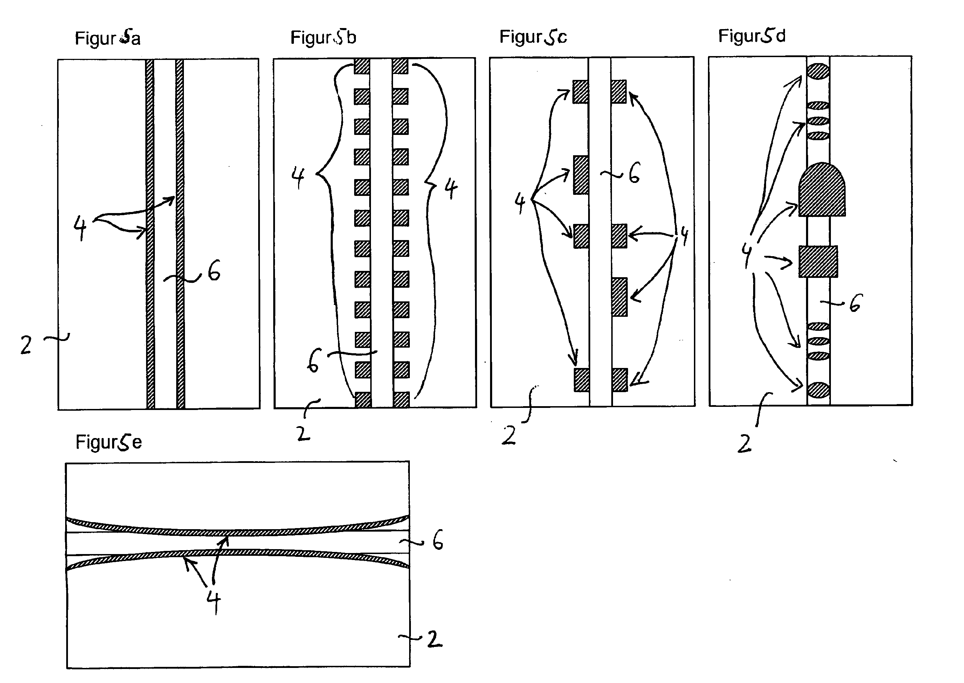

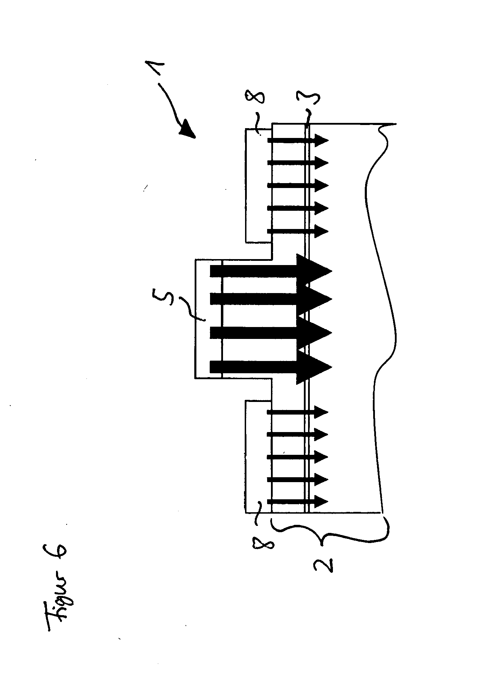

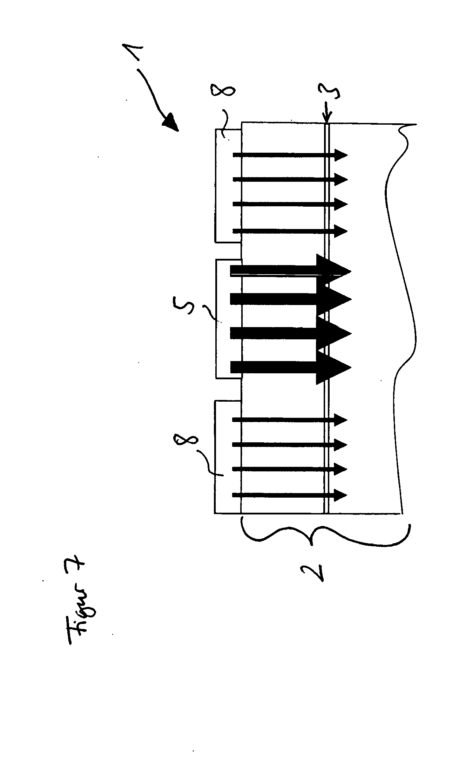

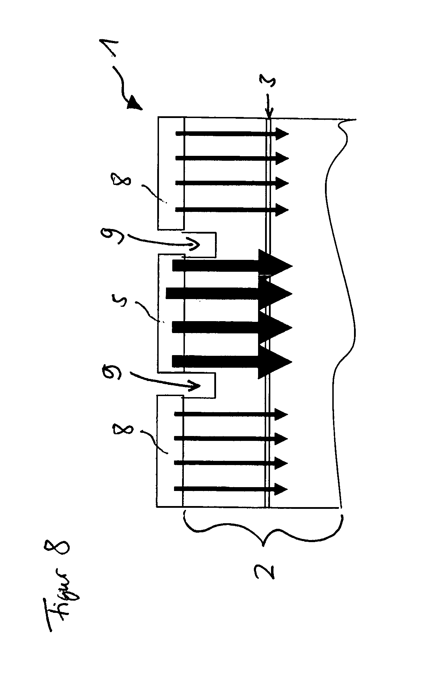

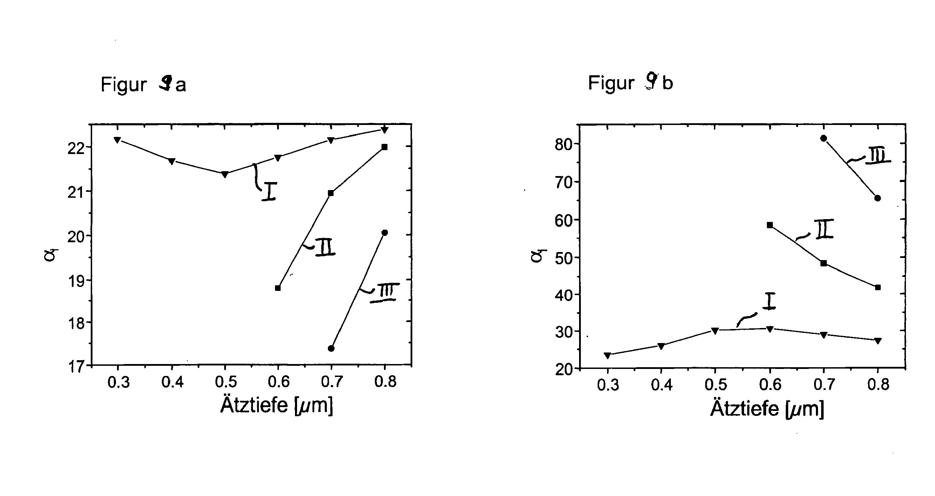

In Figur 2 ist ein Halbleiterlaser 1 dargestellt, der im Vergleich zu dem Halbleiterlaser 1 gemäß Figur 1 eine dünnere Absorberzone 4 aufweist. Um dennoch einen Stromfluss durch die Absorberzone 4 weitgehend zu vermeiden, ist der Absorberzone 4 auf einer der aktiven Zone 3 abgewandten Seite eine Isolierschicht 7 nachgeordnet, die insbesondere elektrisch nichtleitend ist. Vorteilhafterweise können bei dieser Variante die elektrischen Eigenschaften unabhängig von den optischen Eigenschaften beeinflusst werden. Jedoch können auch die optischen Eigenschaften mittels der Isolierschicht 7 beeinflusst werden, beispielsweise indem die Eindringtiefe des Strahlungsfeldes in die Isolierschicht 7 über den Brechungsindex eines für die Isolierschicht 7 verwendeten Materials festgelegt wird. Dadurch kann die Überlappung des Strahlungsfeldes mit der Absorberzone 4 und damit die Absorptionswirkung festgelegt werden.

Beispielsweise kann in diesem Ausführungsbeispiel für die Absorberzone 4 Silizium verwendet werden, während für die Isolierschicht 7 Siliziumoxid verwendet wird. Mittels des Sauerstoff-Anteils kann neben der elektrischen Leitfähigkeit der Brechungsindex beeinflusst werden.

In Figur 3 ist ein Halbleiterlaser 1 dargestellt, dessen Absorptionsgrad im Bereich 4a der Absorberzone 4 auch noch nachträglich, das heißt nach der Herstellung des Halbleiterlasers 1 und oder ersten Messungen der Strahlqualität, einstellbar ist. Die Einstellung erfolgt mittels Diffusion eines Absorbermaterials.

Soll der Absorptionsgrad im Bereich 4a erhöht werden, kann dem Bereich 4a ein Bereich 4b nachgeordnet werden, der ein Absorbermaterial enthält, welches in Pfeilrichtung in den Bereich 4a diffundiert. Hierdurch gelangt das Absorbermaterial näher zur aktiven Zone 3, wodurch die Überlappung mit dem Strahlungsfeld erhöht ist und eine stärkere Absorption stattfindet. Umgekehrt kann der Absorptionsgrad im Bereich 4a erniedrigt werden, indem aus diesem Bereich Absorbermaterial in den Bereich 4b diffundiert. Hierdurch ist das Absorbermaterial von der aktiven Zone 3 weiter entfernt, wodurch die Überlappung mit dem Strahlungsfeld verringert ist und eine geringere Absorption stattfindet.

Insbesondere enthält das Absorbermaterial Einlagerungen. Die Einlagerungen können Atome, Cluster oder Partikel sein, die ein Metall, Halbleitermaterial oder organisches Material enthalten oder daraus bestehen. Insbesondere können die Einlagerungen Ti, Pt, Si oder C enthalten oder daraus bestehen.

Die Diffusion kann thermisch und/oder elektrisch unterstützt sein.

Bei dem in Figur 4 dargestellten Halbleiterlaser 1 ist die Absorberzone 4, die sich aus dem Bereich 4a und dem Bereich 4b zusammensetzt, innerhalb der Halbleiter-Schichtenfolge 2 angeordnet. Die Absorberzone 4 kann in vertikaler Richtung oberhalb, unterhalb oder neben der aktiven Zone 3 angeordnet sein. Beispielsweise kann die Absorberzone 4 als absorbierende Maskenschicht, insbesondere als ELOG-Maskenschicht, in die Halbleiter-Schichtenfolge 2 eingebaut werden, wobei die Absorberzone 4 lateral epitaktisch überwachsen wird. Eine wie in Figur 4 angeordnete Absorberzone 4, die darüber hinaus elektrisch nichtleitend ist, kann zugleich als Stromblende dienen, wodurch der Stromfluss vorteilhaft auf einen zwischen den absorbierenden Bereichen 4a, 4b angeordneten zentralen Bereich der Halbleiter-Schichtenfolge 2 begrenzt wird. Darüber hinaus kann mittels eines geeigneten Brechungsindexsprungs zwischen dem Material der Absorberzone 4 und dem Halbleitermaterial der umgebenden Halbleiter-Schichtenfolge 2 das optische Confinement verbessert werden.

In den Figuren 5a bis 5e sind verschieden strukturierte Absorberzonen 4 dargestellt. Wie in Figur 5d gezeigt kann die strukturierte Absorberzone 4 direkt auf dem Ridge 6 beziehungsweise dem Laserresonator angeordnet sein. Zusätzlich oder alternativ, wie in den Figuren 5a, 5b, 5c und 5e dargestellt, kann die Absorberzone 4 neben dem Ridge 6 beziehungsweise dem Laserresonator angeordnet sein. Mittels der Strukturierung kann die Absorptionswirkung bei einem stark absorbierenden Material vorteilhaft abgeschwächt werden.

Die in Figur 5a dargestellte Absorberzone 4 erstreckt sich zu beiden Seiten längs des Ridges 6 und ist streifenförmig ausgebildet.

Auch die in Figur 5b dargestellte Absorberzone 4 erstreckt sich zu beiden Seiten längs des Ridges 6 und ist in Längsrichtung in voneinander regelmäßig beabstandete, gleich große Rechtecke strukturiert.

Die in Figur 5c dargestellte Absorberzone 4 erstreckt sich ebenso zu beiden Seiten längs des Ridges 6 und ist in Längsrichtung in voneinander unregelmäßig beabstandete, verschieden große Rechtecke strukturiert.

Die in Figur 5d gezeigte Absorberzone 4 ist in verschiedene geometrische Formen, insbesondere in elliptische, rechteckige und halbrunde Formen, strukturiert.

Die in Figur 5e dargestellte Absorberzone 4 erstreckt sich zu beiden Seiten längs des Ridges 6 und ist streifenförmig ausgebildet. Die Streifen sind hierbei an den Enden leicht gekrümmt.

Bei dem in Figur 6 dargestellten Halbleiterlaser 1 ist die Absorption elektrisch eingestellt. Auf der Halbleiter-Schichtenfolge 2 sind zusätzlich zu der Kontaktschicht 5 Metallkontakte 8 vorgesehen, mittels welchen in den Halbleiterlaser 1 Strom injiziert wird. Im Bereich der Metallkontakte 8 wird die aktive Zone 3 durch Pumpen zwischen transparent und stark absorbierend derart eingestellt, so dass insbesondere höhere Moden eine stärkere Absorption erfahren als die Grundmode. Die Metallkontakte 8 werden dabei unabhängig von der Kontaktschicht 5 bestromt. Somit kann die Absorption in den Bereichen der Metallkontakte 8 unabhängig von dem im Bereich der Kontaktschicht 5 stattfindenden Lasing eingestellt werden.

Die in Figur 7 dargestellte Variante eines Halbleiterlasers 1 unterscheidet sich hinsichtlich des Funktionsprinzips nicht von dem in Figur 6 gezeigten Ausführungsbeispiel eines Halbleiterlasers 1. Jedoch weist dieser Halbleiterlaser 1 einen Lasing-Bereich auf, der ausgedehnter ist als bei dem in Figur 6 dargestellten Ausführungsbeispiel. In diesem Fall kann auf ein Abtragen der Halbleiter-Schichtenfolge 2 im Bereich der Metallkontakt 8 verzichtet werden.

Der in Figur 8 dargestellte Halbleiterlaser 1 weist zusätzlich Trenngräben 9 zwischen den Metallkontakten 8 und der Kontaktschicht 5 auf. Dies führt zu einer besseren elektrischen Trennung der Kontakte, so dass eine Stromeinprägung in die Halbleiter-Schichtenfolge 2 hauptsächlich im Bereich unterhalb der Kontaktschicht 5 stattfindet. Ferner kann dadurch eine bessere Wellenführung im Halbleiterlaser 1 erreicht werden.

In den Figuren 9a und 9b sind Simulationen des internen Verlusts αᵢ in Abhängigkeit von der Ätztiefe für einen herkömmlichen Ridgelaser (Figur 9a) und einen erfindungsgemäßen Rigelaser (Figur 9b) dargestellt. Die Abszisse gibt die Ätztiefe, die Ordinate den internen Verlust αᵢ an. Während der herkömmliche Ridgelaser kein Absorbermaterial aufweist, enthält der erfindungsgemäße Ridgelaser als Absorbermaterial TiO, das am Ridge angeordnet ist. Die Ridgebreite beträgt bei beiden Ridgelasern 1,5µm.

Die Kurven I, II und III stellen die Simulationsergebnisse für die Grundmode, die Mode 1. Ordnung und die Mode 2. Ordnung dar.

Wie bei einem Vergleich der Kurven festgestellt werden kann, liegt der interne Verlust αᵢ für höhere Moden unter Verwendung eines Absorbermaterials wesentlich höher als ohne Absorbermaterial. Vorteilhafterweise ist dadurch ein Laserbetrieb in der Grundmode bei geringen Schwellgewinnen und vergleichsweise hohen optischen Ausgangsleistungen möglich.

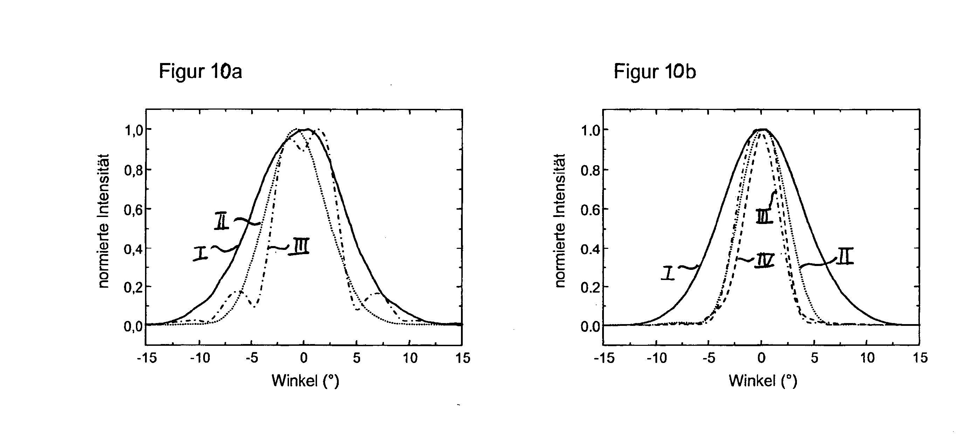

In den Figuren 10a und 10b sind Messergebnisse der winkelabhängigen Intensitätsverteilung dargestellt, die mit verschiedenen Rigelasern gewonnen wurden. Ein herkömmlicher Ridgelaser ohne Absorbermaterial liefert die in Figur 10a dargestellten Messergebnisse, während ein erfindungsgemäßer Ridgelaser mit Absorbermaterial, das in diesem Fall TiO ist, die in Figur 10b dargestellten Messergebnisse liefert.

Die winkelabhängigen Intensitätsverteilungen sind Ergebnisse von Messungen im vertikalen Fernfeld. Die verschiedenen Kurven sind Ridgelasern mit verschiedenen Ridgebreiten zuzuordnen: Kurve I einem Ridgelaser mit einer Ridgebreite von 2,5µm; Kurve II einem Ridgelaser mit einer Ridgebreite von 5µm; Kurve III einem Ridgelaser mit einer Ridgebreite von 8µm, Kurve IV einem Ridgelaser mit einer Ridgebreite von 10µm. Wie aus Figur 10a hervorgeht, entspricht die Intensitätsverteilung eines Ridgelasers ohne Absorber mit einer Ridgebreite von 8µm keiner Gauß-Form mehr. Hingegen weisen die in Figur 10b dargestellten Kurven III und IV für einen erfindungsgemäßen Ridgelaser mit gleichen Ridgebreiten eine Gauß-Form auf.

Somit ist durch den Einsatz des Absorbermaterials die Strahlform im vertikalen Fernfeld deutlich verbessert. Ferner erlaubt der Einsatz des Absorbermaterials, dass auch Ridgelaser mit einem breiteren Ridge in der Grundmode betrieben werden können. Dies hat zum Einen den Vorteil, dass eine Strukturierung der Laserstreifen wesentlich vereinfacht ist, zum Anderen, dass die Betriebsspannung verringert ist, da sich die Kontakt- und Serienwiderstände im Ridgelaser invers zur Ridgebreite verhalten und die Schwellstromdichten bei größeren Ridgebreiten geringer sind als bei kleineren Ridgebreiten. Ferner kann eine größere Ridgebreite zu höheren Ausgangsleistungen führen, da die Leistungsdichte an der Facette geringer ist und somit die kritische Leistungsdichte, die zur Zerstörung der Facette führt (COMD = Catastrophic Optical Mirror Damage), höher ist.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Halbleiterlaser (1) mit
- einer Halbleiter-Schichtenfolge (2), die eine aktive Zone (3) zur Erzeugung von elektromagnetischer Strahlung umfasst, und
- einer Absorberzone (4) zur Dämpfung höherer Moden, wobei die Absorberzone (4) innerhalb der Halbleiter-Schichtenfolge (2) angeordnet ist oder an die Halbleiter-Schichtenfolge (2) angrenzt.

2. Halbleiterlaser (1) nach Anspruch 1, wobei
die Absorberzone (4) ein absorbierendes Material aufweist.

3. Halbleiterlaser (1) nach Anspruch 1 oder 2, wobei
der Absorptionsgrad der Absorberzone (4) mittels der Materialzusammensetzung eingestellt ist.

4. Halbleiterlaser (1) nach Anspruch 2 oder 3, wobei
das absorbierende Material ein Oxid oder Nitrid, insbesondere ein ITO oder ein Oxid oder Nitrid von Si, Ti, A1, Ga, Nb, Zr, Ta, Hf, Zn, Mg, Rh, In ist.

5. Halbleiterlaser (1) nach einem der Ansprüche 2 bis 4, wobei
die Materialzusammensetzung des absorbierenden Materials nicht-stöchiometrisch ist.

6. Halbleiterlaser (1) nach einem der Ansprüche 2 bis 5, wobei
die Absorberzone (4) ein dielektrisches Material aufweist.

7. Halbleiterlaser (1) nach einem der vorhergehenden Ansprüche, wobei
die Absorberzone (4) elektrisch isolierend ist.

8. Halbleiterlaser (1) nach Anspruch 7, wobei
die Absorberzone (4) als Stromblende dient.

9. Halbleiterlaser (1) nach einem der Ansprüche 1 bis 3, wobei
die Absorberzone (4) ein absorbierendes Halbleitermaterial enthält.

10. Halbleiterlaser (1) nach Anspruch 9, wobei
das Halbleitermaterial AlₙGaₘIn₁₋ₙ₋ₘP, AlₙGaₘIn₁₋ₙ₋ₘAs
oder AlₙGaₘIn₁₋ₙ₋ₘN aufweist, wobei 0 ≤ n ≤ 1, 0 ≤ m ≤ 1 und n+m ≤ 1 ist.

11. Halbleiterlaser (1) nach Anspruch 9, wobei
das Halbleitermaterial Si oder Ge ist.

12. Halbleiterlaser (1) nach einem der Ansprüche 9 bis 11, wobei
das absorbierende Halbleitermaterial dotiert ist.

13. Halbleiterlaser (1) nach Anspruch 12, wobei
der Absorptionsgrad der Absorberzone (4) mittels der Dotierung eingestellt ist.

14. Halbleiterlaser (1) nach Anspruch 12 oder 13, wobei
das dotierte Halbleitermaterial mit Mg dotiert ist.

15. Halbleiterlaser (1) nach Anspruch 1, wobei
die Absorberzone (4) mit absorbierenden Einlagerungen versetzt ist.

16. Halbleiterlaser (1) nach Anspruch 15, wobei
der Absorptionsgrad der Absorberzone (4) mittels des Anteils der Einlagerungen eingestellt ist.

17. Halbleiterlaser (1) nach Anspruch 15 oder 16, wobei
die Einlagerungen Atome, Cluster oder Partikel sind, die ein Metall, Halbleitermaterial oder organischen Material enthalten oder daraus bestehen.

18. Halbleiterlaser (1) nach Anspruch 17, wobei
die Einlagerungen Ti, Pt, Si oder C enthalten oder daraus bestehen.

19. Halbleiterlaser (1) nach einem der Ansprüche 15 bis 18, wobei
die Absorberzone (4) ein Oxid oder Nitrid, insbesondere ein ITO oder ein Oxid oder Nitrid von Si, Ti, A1, Ga, Nb, Zr, Ta, Hf, Zn, Mg, Rh, In oder ein Polyimid enthält.

20. Halbleiterlaser (1) nach Anspruch 1, wobei
die Absorberzone (4) ein Übergitter aufweist, das aus einer Abfolge von mindestens einer Schicht, die ein absorbierendes Material enthält, und mindestens einer Schicht, die ein weniger absorbierendes Material enthält, gebildet ist.

21. Halbleiterlaser (1) nach Anspruch 1, wobei
der Absorptionsgrad der Absorberzone (4) durch Aufnahme eines Absorbermaterials in die Absorberzone (4) oder Abgabe eines Absorbermaterials aus der Absorberzone (4) mittels Diffusion eingestellt ist.

22. Halbleiterlaser (1) nach einem der vorhergehenden Ansprüche, wobei
die Absorberzone (4) strukturiert ist.

23. Halbleiterlaser (1) nach Anspruch 22, wobei
die Absorberzone (4) eine punktförmige, streifenförmige oder feldlinienartige Struktur aufweist.

24. Halbleiterlaser (1) nach einem der vorhergehenden Ansprüche, wobei
die Absorberzone (4) innerhalb der Halbleiter-Schichtenfolge (2) angeordnet ist.

25. Halbleiterlaser (1) nach Anspruch 24, wobei
die Absorberzone (4) epitaktisch überwachsen ist.

26. Halbleiterlaser (1) nach Anspruch 1, wobei
die Absorberzone (4) an die Halbleiter-Schichtenfolge (2) angrenzt.

27. Halbleiterlaser (1) nach Anspruch 26, wobei
die Absorberzone (4) mittels Veränderung der Kristallstruktur der Halbleiter-Schichtenfolge (2) aus einer die Halbleiter-Schichtenfolge (2) abschließenden Schicht gebildet ist.

28. Halbleiterlaser (1) nach Anspruch 27, wobei
die Kristallstruktur mittels Plasma- oder Temperatureinwirkung verändert ist.

29. Halbleiterlaser (1) nach Anspruch 26, wobei
die Absorberzone (4) aus einer Metallschicht gebildet ist.

30. Halbleiterlaser (1) nach Anspruch 29, wobei
die Metallschicht ein Metall, insbesondere Ti oder Cr, mit einer niedrigen Austrittsarbeit enthält.

31. Halbleiterlaser (1) nach einem der Ansprüche 26 bis 30, wobei
auf einer der Halbleiter-Schichtenfolge (2) abgewandten Seite der Absorberzone (4) eine elektrische Isolierschicht (7) angeordnet ist.

32. Halbleiterlaser (1) nach Anspruch 31, wobei
die Isolierschicht (7) einen von der Absorberzone (4) verschiedenen Brechungsindex aufweist.

33. Halbleiterlaser (1) nach Anspruch 26, wobei
die Absorberzone (4) einen Metallkontakt (8) zur elektrischen Einstellung der Absorption aufweist.

34. Halbleiterlaser (1) nach einem der vorhergehenden Ansprüche, der ein Ridgelaser ist.

35. Halbleiterlaser (1) nach Anspruch 34, wobei
sich die Absorberzone (4) in lateraler Richtung erstreckt.

36. Halbleiterlaser (1) nach Anspruch 34 oder 35, wobei
die Absorberzone (4) in vertikaler Richtung zur aktiven Zone (3) beabstandet ist.

37. Halbleiterlaser (1) nach einem der vorhergehenden Ansprüche, wobei
die Absorberzone (4) mittels Sputtern, Aufdampfen, epitaktischem Aufwachsen oder Plasmabeschichten erzeugt ist.
